# EUROPEAN PATENT APPLICATION

(11) **EP 2 157 622 A2**
(43) Date of publication of application: **24.02.2010**
(21) Application number: 09168412.6
(22) Date of filing: 21.08.2009
(51) Int. Cl.: H01L 31/18, H01L 31/0224

(54) **Solar cell substrates and methods of manufacture**

(30) Priority: 21.08.2008 US 196001
(71) Applicant: Applied Materials, Inc., Santa Clara, CA 95054 (US)
(72) Inventor: Le, Hien-Minh H., San Jose, CA 95148 (US); Tanner, David, San Jose, CA 95126 (US)
(74) Representative: Zimmermann, Gerd Heinrich

(57) **Abstract**

Photovoltaic cells and methods for making photovoltaic cells are described.
The methods include disposing an intermediate layer 134 within the back contact 130 at a thickness that does not negatively impact reflection or transmission of light through the solar cell. The intermediate layer prevents peeling of metal from the back contact during laser scribing.

## Description

Embodiments of the present invention generally relate to photovoltaic cells and fabrication of photovoltaic cells. In particular, embodiments of the invention relate to methods of improving the fabrication of solar cells, particularly during laser scribing.

Photovoltaic (PV) or solar cells are material junction devices which convert sunlight into direct current (DC) electrical power. When exposed to sunlight (consisting of energy from photons), the electric field of solar cell p-n junctions separates pairs of free electrons and holes, thus generating a photo-voltage. A circuit from n-side to p-side allows the flow of electrons when the solar cell is connected to an electrical load, while the area and other parameters of the PV cell junction device determine the available current. Electrical power is the product of the voltage times the current generated as the electrons and holes recombine.

Solar cells have evolved significantly over the past two decades, with experimental efficiencies increasing from less than about 5% in 1980 to almost 40% in 2008. The most common solar cell material is silicon, which is in the form of single or polycrystalline wafers. Because the amortized cost of forming silicon-based solar cells to generate electricity is higher than the cost of generating electricity using traditional methods, there has been an effort to reduce the cost to form solar cells. In particular, thin-film techniques enable streamlined, high-volume manufacturing of solar cells and greatly reduced silicon consumption.

Thin-film solar devices typically consist of multiple thin layers of material deposited on sheet glass. Presently, a dominant solar cell thin-film is based on amorphous silicon (α-Si) in a so-called single-junction configuration in which a transparent conductive oxide (TCO) layer is deposited on a glass substrate, and an amorphous silicon layer is deposited on the TCO layer, and the back contact comprises an aluminum doped zinc oxide (AZO) layer over the α silicon layer, with an aluminum layer over the AZO layer and NiV over the aluminum layer. Tandem junction devices comprise a transparent conductive oxide (TCO) layer deposited on glass, with an α silicon layer deposited over the TCO layer, and a back contact over the α silicon layer, which comprises an AZO layer over the α silicon layer, with a silver layer over the AZO layer and NiV over the silver layer.

Currently, solar cells and PV panels are manufactured by starting with many small silicon sheets or wafers as material units and processed into individual photovoltaic cells before they are assembled into PV modules and solar panels. These glass panels are typically subdivided into a large number (between 100 and 200) of individual solar cells by scribing processes that also define the electrical interconnects for adjacent cells. This scribing creates low-current active 'strips,' typically only 5-10 mm wide, which are electrically connected in series to produce high power (from tens of watts to a couple hundred watts, typically) with currents of a few amps. Laser scribing enables high-volume production of next-generation thin-film devices, and laser scribing outperforms mechanical scribing methods in quality, speed, and reliability.

Existing processes to produce solar panels using laser scribing can cause problems particularly when silver is used in the manufacture of the back contact over the AZO layer. In particular, during laser scribing the silver may peel from the AZO, which may cause chips and defects to form in the scribed strip area, which may cause shorting in the solar cell device. In addition, the solar cell may suffer from other problems due to the sliver peeling from the AZO layer, namely decreasing reflection from the solar cell. This may cause the α silicon layer to generate more current. Therefore, there is a need for effective solar cell p-n junction formation to improve the fabrication process of solar cells.

In light of the above, a method of making a photovoltaic device according to independent claim 1 and a photovoltaic cell according to independent claim 11 are provided.

Aspects of this invention involve photovoltaic cells and methods of making photovoltaic devices. In one embodiment, a method of making a photovoltaic device comprises depositing a transparent conductive oxide layer on a glass substrate; depositing a silicon layer over transparent conductive oxide layer; forming a back contact over silicon layer, including forming a zinc oxide layer deposited over the silicon layer, depositing an intermediate layer over the silicon layer; and depositing a silver layer over the intermediate layer; laser scribing through the back contact.

In one embodiment, the intermediate layer is deposited at a thickness so that transmission of light through the device at wavelengths between about 550 nm and 850 nm is within 5% of the transmission of light through a photovoltaic device that does not have an intermediate layer in the back contact. In one embodiment, the intermediate layer is deposited at a thickness so that the reflection of light in the device at a wavelength between about 800 nm and 1000 nm is within about 5% of reflection of light through a photovoltaic device that does not have an intermediate layer in the back contact.

In one or more embodiments, the laser scribing through the back contact does not result in flaking of the silver layer. In one embodiment, the intermediate layer comprises one or more of Cr, Ti, Mo, Si, oxides of Cr, Ti, Mo and Si, and combinations thereof. For example, the intermediate layer may comprise an oxide of Cr, such as, Cr₂O₃. In one or more embodiments, the intermediate layer has a thickness less than about 35 Å, and in particular embodiments, less than about 20 Å.

In one embodiment, the intermediate layer is deposited at a thickness so that transmission of light through the device at wavelengths between about 550 nm and 850 nm is within 5% of the transmission of light through a photovoltaic device that does not have an intermediate layer in the back contact. In another embodiment, the intermediate layer is deposited at a thickness so that the reflection of light in the device at a wavelength between about 800 nm and 1000 nm is within about 5% of reflection of light through a photovoltaic device that does not have an intermediate layer in the back contact.

Another aspect of the invention, a photovoltaic cell comprises a transparent conductive oxide layer on a glass substrate; a silicon layer on the transparent conductive oxide layer; and a back contact including AZO layer, an intermediate layer having a thickness less than about 35 Å; and a silver layer over the intermediate layer. In one embodiment, the intermediate layer comprises one or more of Cr, Ti, Mo, Si, oxides of Cr, Ti, Mo and Si, and combinations thereof. In a specific embodiment, the intermediate layer comprises Cr₂O₃. In another specific embodiment, the intermediate layer has a thickness less than about 20 Å. In one embodiment, the intermediate layer has a thickness so that transmission of light through the device at wavelengths between about 550 nm and 850 nm is within 5% of the transmission of light through a photovoltaic device that does not have an intermediate layer in the back contact. In another embodiment, the intermediate layer has a thickness so that the reflection of light in the device at a wavelength between about 800 nm and 1000 nm is within about 5% of reflection of light through a photovoltaic device that does not have an intermediate layer in the back contact.

Further advantages, features, aspects and details are evident from the dependent claims, the description and the drawings.

Embodiments are also directed to apparatuses resulting from the disclosed methods and including apparatus parts corresponding to the described method steps. Furthermore, embodiments are also directed to methods by which the described apparatuses are manufactured. It may include method steps for manufacturing parts of the apparatus. The method steps may be performed by way of hardware components, firmware, software, a computer programmed by appropriate software, by any combination thereof or in any other manner.

So that the manner in which the above recited features of the present invention can be understood in detail, a more particular description of the invention, briefly summarized above, may be had by reference to embodiments. The accompanying drawings relate to embodiments of the invention and are described in the following:

Fig. 1 schematically illustrates a glass substrate coated with a transparent conductive oxide;

Fig. 2 shows the glass substrate of Fig. 1 after strips have been laser scribed through the transparent conductive oxide layer;

Fig. 3 show the glass substrate of Fig. 2 after a silicon layer has been deposited on the transparent conductive oxide layer;

Fig. 4 shows the glass substrate of Fig. 3 after the silicon layer has been laser scribed;

Fig. 5 shows the glass substrate of Fig. 4 after a metal layer has been deposited over the silicon layer;

Fig. 6 shows the glass substrate of Fig. 5 after the metal layer and underlying transparent conductive oxide have been laser scribed;

Fig. 7 shows a layering structure on a solar cell in accordance with an embodiment of the invention;

Fig. 8 shows a TEM (Transmission Electron Microscopy) photograph of a laser scribed module in accordance with the prior art;

Fig. 9 shows a TEM photograph of a laser scribed solar cell made in accordance with an embodiment of the present invention;

Fig. 10 shows a graph of transmission versus wavelength for samples including intermediate Cr layers compared to a sample with no intermediate layer;

Fig. 11 shows a graph of reflection versus wavelength for samples including intermediate Cr layers compared to a sample with no intermediate layer;

Fig. 12 shows a TEM photograph of a sample including an intermediate layer made in accordance with an embodiment of the invention; and

Fig. 13 shows the QE versus wavelength for tandem junction solar cells made in accordance with prior art methods compared to solar cells made in accordance with an embodiment of the present invention.

Before describing several exemplary embodiments of the invention, it is to be understood that the invention is not limited to the details of construction or process steps set forth in the following description. The invention is capable of other embodiments and of being practiced or being carried out in various ways.

As used in this specification and the appended claims, the singular forms "a", "an" and "the" include plural referents unless the context clearly indicates otherwise. It will be understood that the laser-scribing processes described herein are applicable to all types of thin-film solar cell manufacturing, including those based on CdTe (cadmium telluride) and cigs (copper indium gallium selenide).

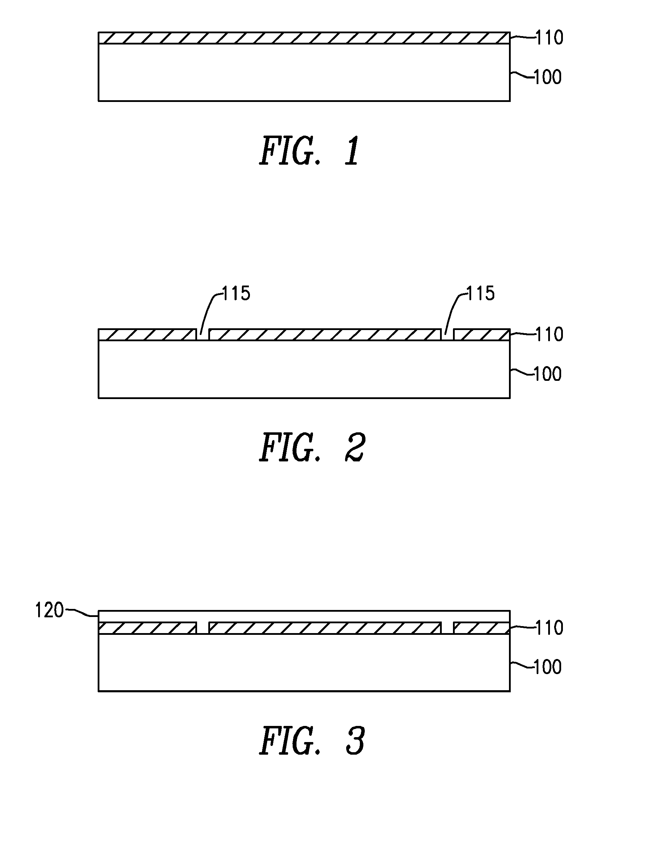

Referring to Figs. 1-6 an exemplary embodiment of a manufacturing process for solar cells is shown. Starting at Fig. 1, solar cells are manufactured by starting with a glass sheet or substrate 100. An exemplary thickness for the glass sheet is about 3 mm. In the art, this glass substrate actually is called a glass superstrate, because sunlight will enter through this support glass. During the manufacture of a solar cell, first a continuous, uniform layer of TCO (transparent conductive oxide) 110 is deposited on the glass substrate 100. The thickness of the TCO layer 110 is typically a few hundred nanometers. The TCO layer eventually forms the front electrodes of the solar cell. Suitable materials for the TCO layer include AZO, and SnO₂, and the TCO layer can be deposited by any suitable process such as chemical vapor deposition or sputtering.

Referring now to Fig. 2, after deposition of the TCO layer, this is followed by a laser scribing process, which is often referred to as P1, which scribes strips 115 through the entire TCO layer thickness. As shown in Fig. 3, after this first scribing process P1, a p- and n-type silicon layer 120 is deposited over the TCO layer, and the silicon layer, which is typically ά silicon. The total thickness of the silicon layer is typically on the order of 0.5-3µm, and this layer is usually deposited by chemical vapor deposition or other suitable processes.

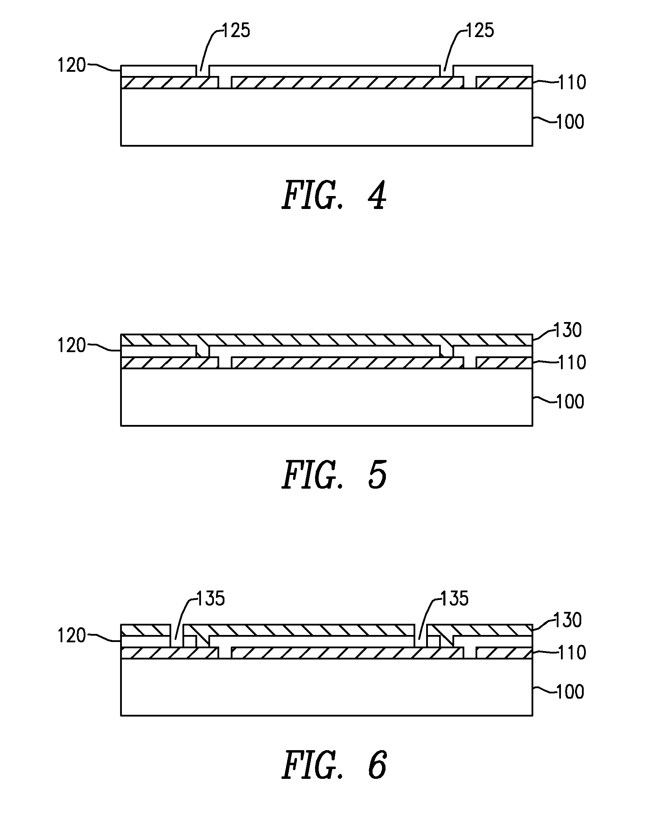

Referring to Fig. 4, the silicon deposition step is followed by a second laser scribing step, often referred to as P2, which completely cuts strips 125 through the silicon layer 120. As shown in Fig. 5, a metal back contact 130 that forms the rear electrodes is deposited over the silicon layer 120. The metal back contact 130 may be any suitable metals such as aluminum, silver, or molybdenum, and this back contact can be deposited by a suitable deposition process such as physical vapor deposition. Typically the metal back contact 130 will comprise several individual layers as described in more detail below. Referring now to Fig. 6, a third scribe process, called P3, is used to scribe strips 135 through the metal back contact 130 and the silicon layer 120. The panel is then sealed with a rear surface glass lamination.

In specific embodiments, in the manufacture of tandem junction devices, the back contact 130 may comprise several layers overlying the α silicon layer. In a specific configuration, an AZO layer is first deposited over the α silicon layer, and then a silver layer is deposited over the AZO layer. Thereafter, a NiV layer may be deposited over the silver layer. It will be understood that the present invention is not limited to particular metals for the back contact 130.

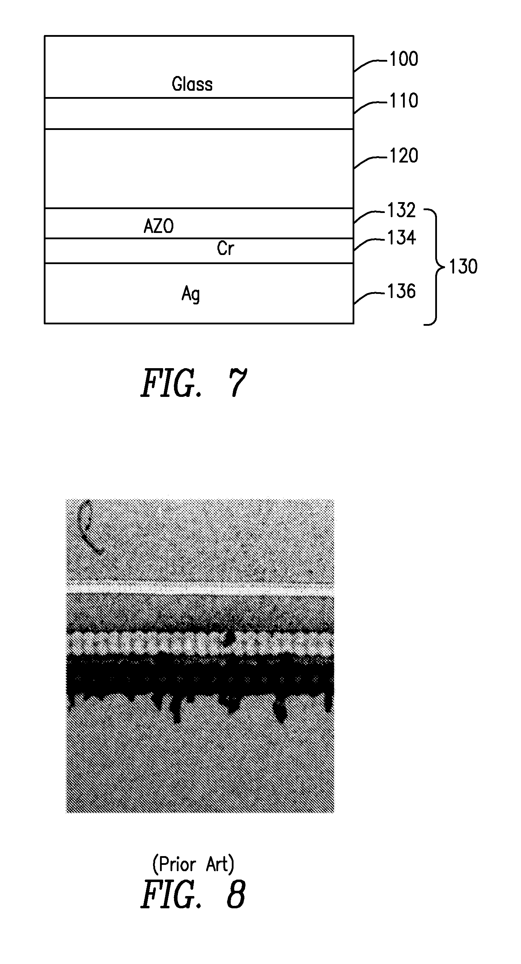

During the P3 cut for devices with a silver layer over an AZO layer, it has been observed that silver in the scribed area has a tendency to flake and cause defects, which results in poor cell performance. Figure 8 is an SEM photograph at 100X magnification showing silver flaking (black particles) after a P3 laser scribe of a solar cell with a back contact comprising silver over AZO. It is believed that the peeling and flaking is due to poor adhesion of the silver to the AZO material. One approach that was investigated to improve adhesion of the silver to the AGO layer was to increase the thickness of the silver layer, but this did not result in a noticeable improvement. In addition, an oxygen argon plasma process was investigated, which appeared to improve adhesion between the silver and the AZO layers, however, it was difficult to control plasma uniformity across the deposition chamber.

Various materials were then considered to provide an intermediate layer between the silver and the AZO layer of the back contact. However, the addition of any material layer under the silver layer of a solar cell must be carefully considered because the silver layer serves an extremely important function of not only conducting electricity, but also reflecting light. Accordingly, the application of an intermediate layer between the silver and AZO layers must not adversely impact reflection in the solar cell or light transmission in the cell.

Several material candidates were considered for the intermediate layer. Several criteria had to be considered in selecting an appropriate material for the intermediate layer. One factor was the heat of formation of several metals to oxygen. Initially, materials having higher heats of formation to oxygen were favored. However, certain materials that had desirable heats of formation were eliminated from consideration because of the difficulty in forming metal oxides. Another factor that was considered was the transparency of metal oxide films and their impact on reflectivity of the silver layer and transmission of light in the solar cell. Materials that were considered included Ta, Al, V, Cr, Ti and Mo. Materials that were selected as good candidates as intermediate film layer materials include Cr, Ti, W, and Ni. In addition, alloys of silver with Ag, Ti, W, Ni and Si were selected as candidate materials for the intermediate layer. Of these materials, CrₓO_{y} materials were selected for further testing.

Referring now to Fig. 7, a specific embodiment of a layering structure is shown in accordance with an embodiment of the invention. Glass substrate 100 is shown as having a TCO layer 110, an α silicon layer 120, and a metal back contact 130. The metal back contact 130 comprises three layers. Initially, an AZO layer 132 is deposited on the α silicon layer, and a Cr layer 134 is deposited as an intermediate layer of the back contact prior to deposition of the silver layer 136. The Cr layer 134 helps to increase adhesion between the AZO layer 132 and the Ag layer 136. In addition, a thin Cr layer will react with O₂ from AZO film to Cr₂O₃. Further testing as discussed below revealed that Cr₂O₃ was transparent to light and did not reduce reflection in the solar cell. The thickness of the intermediate layer 134 must be of a thickness so that the layer 134 does not absorb light and does not negatively impact reflection within the solar cell. For Cr layers, it was determined that a chrome layer having a thickness in the range of about 15Å- 20Å thickness provided optimum results.

In summary, the intermediate layer must meet several criteria to be acceptable for use in a solar cell. The intermediate layer should increasing adhesion by wetting the AZO surface with a thin metal and/or provide a good chemical reaction between AZO and Ag. The layer must be thin enough not to absorb all the light and be reasonable in terms of cost and manufacturing. Thus it would be desirable to provide a material that can be deposited by a process such as physical vapor deposition sputtering.

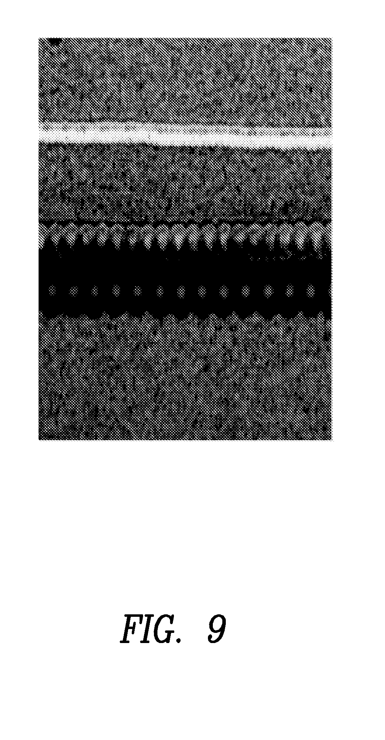

After conducting initial experiments to determine that Cr was an optimal material for the intermediate layer, performance testing was conducted to ensure that Cr would be acceptable for use in solar cell applications. Fig. 9 shows a solar cell with a back contact having the structure shown in Fig. 7 and P3 laser scribing. As shown in Fig. 9 and comparing to Fig. 8, which did not use an intermediate layer, there is no flaking of silver particles, and the silver adhered well.

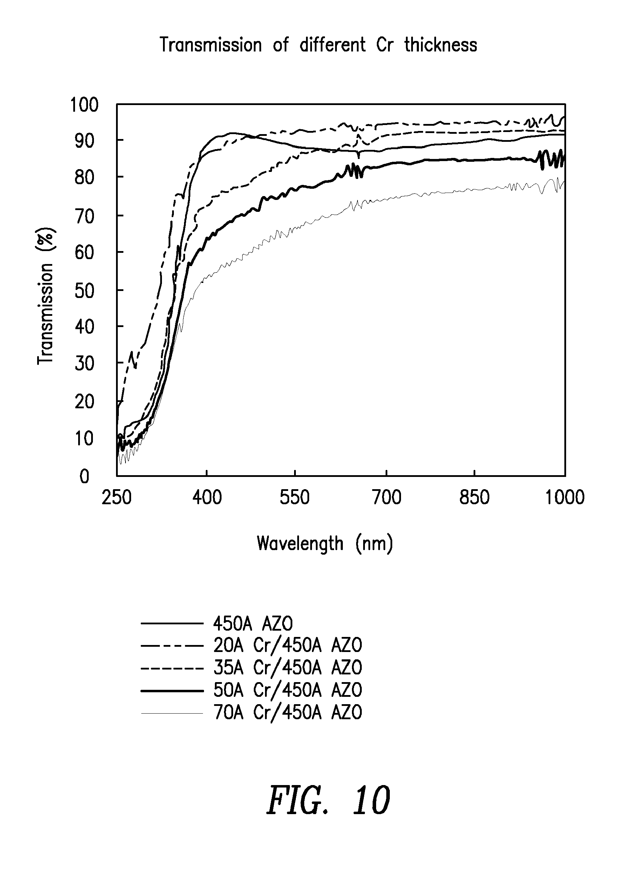

After confirming that the intermediate Cr layer provided acceptable adhesion between AZO and Ag, transmission and reflection testing of films having an intermediate Cr layer between the AZO and silver layers of the back contact was then conducted to ensure that the intermediate layer did not adversely impact solar cell performance. Four samples with different Cr layer thicknesses on (70 Å, 50 Å, 35 Å and 20 Å) were deposited on AZO layers that were 450 Å thick and a sliver layer that was 2000 Å thick was deposited on each of the Cr layers. The transmission results obtained by using a spectrometer, shown in Fig. 10 indicate that the 20 Å layer thickness performed similarly to the sample that did not have an intermediate layer. Therefore, it was determined that a Cr layer having a thickness less than about 35 Å, and in particular, less than about 20 Å provided optimal results. It will be understood, of course, that different materials may require different layer thicknesses to achieve acceptable results.

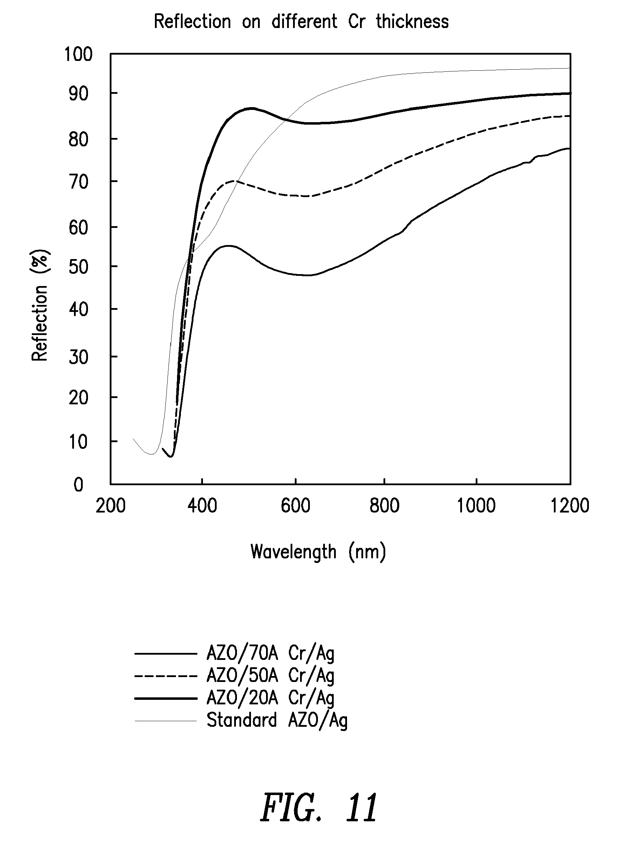

Reflection testing was next performed on samples having an intermediate Cr layers with thicknesses of about 20 Å, 50nÅ, and 70 Å, which were compared with a standard AZO/Ag back contact. In each of the samples, the AZO thickness was 450 Å and the silver layer thickness was 2000 Å. Fig. 11 shows the reflection results. The sample with a Cr layer having a thickness of about 20 Å exhibited results that were similar to the standard sample. Samples having a reflection that are within about 4% of the reflection of a standard sample provided acceptable results.

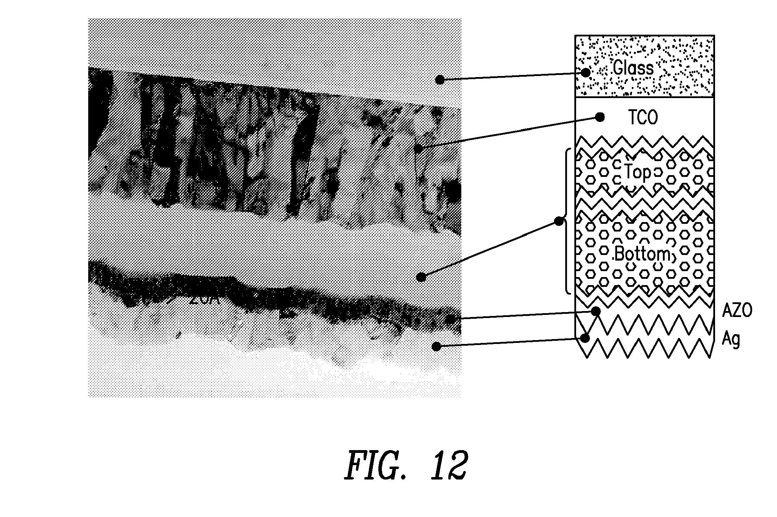

A sample with a 20 Å intermediate back contact layer was examined using a transmission electron microscope (TEM), and Fig. 12 shows the TEM view at next to a schematic drawing of the layers. As seen in Fig. 12, the Cr intermediate layer was not apparent from the TEM view, which was probably due to the fact that the Cr layer was about 20 Å in thickness.

Solar cell performance of devices made with intermediate Cr back contact layers was tested to determine if the intermediate layer adversely impacted solar cell performance. Single junction and tandem junction solar cell performance was tested. Solar cell with single junctions having intermediate Cr back contact layers exhibited acceptable performance. Samples were made by forming a TCO layer on glass, which was washed by DI water, and then PECVD was used to deposit a silicon layer. A back contact was then formed with four different layers, AZO, Cr, and Ag using sputtering. The samples were measured on a current and voltage measurement tool available from Newport Oriel. The results showed that the current (Jsc) was generated by a sample with a back contact (AZO/Cr/Ag) performed similarly to a sample with AZO/Ag, indicating that the Cr did not reduce the performance of solar cell.

| | **Single Junction** | | | | |
|---|---|---|---|---|---|
| **Back Contact** | AZO/Ag | AZO/Al | AZO/Cr/Ag 70Å Cr | AZO/Cr/Ag 50Å Cr | AZO/Cr/Ag 20Å Cr |
| **Before PMA** | | | | | |
| CE (%) | 7.34 | 7.84 | 7.41 | 7.74 | 7.80 |
| Jsc (mA/cm²) | 12.42 | 12.35 | 11.78 | 12.23 | 12.42 |
| Voc (V) | 0.889 | 0.917 | 0.903 | 0.908 | 0.907 |
| FF (%) | 66.4 | 69.3 | 69.7 | 69.7 | 69.3 |
| Rsh (Ohm) | 3339 | 4285 | 3786 | 3540 | 3893 |
| Rs (Ohm) | 19 | 18 | 18 | 18 | 17 |

| **After PMA** | | | | | |
|---|---|---|---|---|---|
| CE (%) | 8.17 | 8.22 | 7.91 | 8.17 | 8.34 |
| Jsc (mA/cm²) | 12.59 | 12.32 | 11.89 | 12.33 | 12.58 |
| Voc (V) | 0.910 | 0.928 | 0.906 | 0.912 | 0.910 |
| FF (%) | 71.3 | 72.9 | 73.4 | 72.7 | 72.9 |
| Rsh (Ohm) | 3533 | 5093 | 4286 | 3658 | 4303 |
| Rs (Ohm) | 13 | 14 | 13 | 13 | 13 |

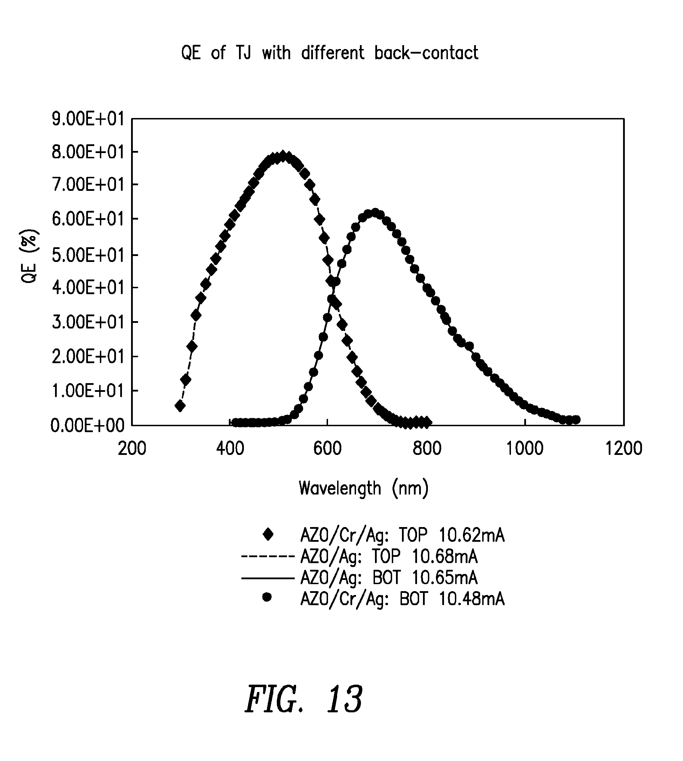

Tandem junction cells with an intermediate Cr back contact layer were tested to determine if solar cell performance was acceptable. Samples were made by forming a TCO layer on glass, which was washed by DI water, and then PECVD was used to deposit a silicon layer. A back contact was then formed with four different layers, AZO, Cr, and Ag using sputtering. The samples were measured on a current and voltage measurement tool available from Newport Oriel. As can be seen in the Table below, the presence of Cr did not reduce the performance of solar cell in terms of similar Jsc and efficiency (CE%). Testing of tandem junction solar cells showed that solar cells having a thin intermediate Cr layer in the back contact exhibited similar cell performance to solar cells having an AZO/Ag back contact structure. Fig. 13 shows comparison of QE (Quantum efficiency) of measurements from the bottom and top of solar cells having 20 Å thick intermediate Cr layers between the Ag and AZO back contact layers compared to a standard cell with Ag deposited on AZO with no intermediate layer. As seen in Fig. 13 and the table below, there was very little difference in QE.

| | **Tandem Junction** | |
|---|---|---|
| **Back Contact** | AZO/Ag | AZO/Cr/Ag 20Å Cr |
| **Before PMA** | | |
| CE (%) | 9.67 | 9.91 |
| Jsc (mA/cm²) | 11.41 | 11.24 |
| Voc (V) | 1.291 | 1.326 |
| FF (%) | 65.6 | 66.5 |
| Rsh (Ohm) | 2676 | 4136 |
| Rs (Ohm) | 30 | 29 |

| **After PMA** | | |
|---|---|---|
| CE (%) | 10.26 | 10.53 |
| Jsc (mA/cm²) | 11.54 | 11.40 |
| Voc (V) | 1.318 | 1.355 |
| FF (%) | 67.4 | 68.2 |
| Rsh (Ohm) | 2536 | 3323 |
| Rs (Ohm) | 24 | 22 |

Further testing of 30 cm X 30 cm solar cell modules with tandem junctions having an intermediate Cr layer resulted in acceptable performance, and revealed that the Ag material can be soldered for bus wire processes, and environmental testing of 800 hours was acceptable. Tandem junction solar cells exhibited 7.3W (9.97% efficiency) compared to the standard with 6.3W (8.6% efficiency) on 30x30cm modules.

The manufacturing of solar cells in accordance with embodiments of the invention can performed in a vacuum deposition chamber. The vacuum deposition chamber can be a stand-alone chamber or as part of a sheet processing system. In some cases, the vacuum deposition chamber may be part of a multi-chamber system. The glass substrate 100 can be a glass sheet suitable for solar cell fabrication is used. A sheet size of about 50 mm X 50 mm or larger can be used. Typical sheet size for solar cell fabrication may be about 100 mm X 100 mm or larger, such as about 156 mm x 156 mm or larger in size; however, smaller or larger sizes/dimensions can also be used to advantage, e.g., a size of about 400 mm X 500 mm can also be used. The thickness of a solar cell sheet may, for example, be a few hundred microns, such as between about 100 microns to about 350 microns. Each sheet may be suitable for forming a single p-n junction, a dual junction, a triple junction, tunnel junction, p-i-n junction, or any other types of p-n junctions created by suitable semiconductor materials for solar cell manufacturing. In another embodiment, at least a surface of the sheet may include p-type silicon material thereon.

The laser scribing processes P1, P2 and P3 can be carried out with any suitable laser scribing tool. Scribe lines are currently on the order of several tens of microns in width. The P1 scribe process typically uses lasers with up to 8 W of near-IR, and the P2 and P3 processes typically only need a few hundred milliwatts of green output.

After the solar cell is formed as described above, the cell may be heat treated by annealing. In addition, the sheet may be subjected to a variety of wiring schemes and/or surface treatment steps.

A suitable vacuum deposition chamber may include various chemical vapor deposition chambers. As noted above, the silicon layer is deposited by plasma enhanced chemical vapor deposition (PECVD). The PECVD system may be configured to process various types of sheets, such as various parallel-plate radiofrequency (RF) plasma enhanced chemical vapor deposition (PECVD) systems for various sheet sizes, available from AKT, a division of Applied Materials, Inc., Santa Clara, Calif. However, it should be understood that the invention has utility in other system configurations, such as other chemical vapor deposition systems and any other film deposition systems.

For solar cell fabrication, additional layers can be deposited on the sheet. For example, one or more passivation layer or anti-reflective coating layer can be deposited on the front and/or back side of the sheet. In addition, a plurality of features can then be patterned on the sheet using any of suitable patterning techniques, including, but not limited to, dry etch, wet etch, laser drilling, chemical mechanical jet etch, and combinations thereof.

Although the invention herein has been described with reference to particular embodiments, it is to be understood that these embodiments are merely illustrative of the principles and applications of the present invention. The CVD, PVD and other processes herein can be carried out using other CVD chambers, adjusting the gas flow rates, pressure, plasma density, and temperature so as to obtain high quality films at practical deposition rates. It is understood that embodiments of the invention include scaling up or scaling down any of the process parameter/variables as described herein according to sheet sizes, chamber conditions, etc., among others. It will be apparent to those skilled in the art that various modifications and variations can be made to the method and method of the present invention without departing from the spirit and scope of the invention. Thus, it is intended that the present invention include modifications and variations that are within the scope of the appended claims and their equivalents.

## Claims

1. A method of making a photovoltaic device comprising:
depositing a transparent conductive oxide layer (110) on a glass substrate (100);
depositing a silicon layer (120) over transparent conductive oxide layer;
forming a back contact (130) over silicon layer, including forming a zinc oxide layer deposited over the silicon layer, depositing an intermediate layer over the silicon layer; and depositing a silver layer over the intermediate layer (134); and
laser scribing through the back contact.

2. The method of claim 1, wherein laser scribing through the back contact does not result in flaking of the silver layer.

3. The method of claim 1 or 2, wherein the intermediate layer comprises Cr.

4. The method of claim 1 or 2, wherein the intermediate layer (134) comprises one or more of Cr, Ti, Mo, Si, oxides of Cr, Ti, Mo and Si, and combinations thereof.

5. The method of claim 1 or 2, wherein the intermediate layer comprises an oxide of Cr.

6. The method of claim 5, wherein the intermediate layer comprises Cr₂O₃.

7. The method of any of claims 1 to 6, wherein the intermediate layer has a thickness less than about 35 Å.

8. The method of claim 7, wherein the intermediate layer (134) has a thickness less than about 20 Å.

9. The method of any of claims 1 to 8, wherein the intermediate layer is deposited at a thickness so that transmission of light through the device at wavelengths between about 550 nm and 850 nm is within 5% of the transmission of light through a photovoltaic device that does not have an intermediate layer in the back contact.

10. The method of any of claims 1 to 9, wherein the intermediate layer is deposited at a thickness so that the reflection of light in the device at a wavelength between about 800 nm and 1000 nm is within about 5% of reflection of light through a photovoltaic device that does not have an intermediate layer in the back contact.

11. A photovoltaic cell comprising:
a transparent conductive oxide layer (110) on a glass substrate (100);
a silicon layer (120) on the transparent conductive oxide layer; and
a back contact (130) including AZO layer, an intermediate layer having a thickness less than about 35 Å; and a silver layer over the intermediate layer.

12. The photovoltaic cell of claim 11, wherein the intermediate layer comprises one or more of Cr, Ti, Mo, Si, oxides of Cr, Ti, Mo and Si, and combinations thereof.

13. The photovoltaic cell of claim 12, wherein the intermediate layer comprises Cr₂O₃ and the intermediate layer has a thickness less than about 20 Å.

14. The photovoltaic cell of any of claims 11 to 13, wherein the intermediate layer is has a thickness so that transmission of light through the device at wavelengths between about 550 nm and 850 nm is within 5% of the transmission of light through a photovoltaic device that does not have an intermediate layer in the back contact.

15. The photovoltaic cell of any of claims 11 to 14, wherein the intermediate layer (134) has a thickness so that the reflection of light in the device at a wavelength between about 800 nm and 1000 nm is within about 5% of reflection of light through a photovoltaic device that does not have an intermediate layer in the back contact.
